(19) Europäisches Patentamt
European Patent Office
Office européen des brevets

(11) **EP 2 211 148 B1**

(12) **EUROPÄISCHE PATENTSCHRIFT**

(45) Veröffentlichungstag und Bekanntmachung des Hinweises auf die Patenterteilung:
**09.10.2013 Patentblatt 2013/41**

(51) Int Cl.:
*G01D 5/20* (2006.01)          *H02K 24/00* (2006.01)
*H03M 1/64* (2006.01)          *H02P 13/10* (2006.01)
*H03M 1/10* (2006.01)

(21) Anmeldenummer: **09015331.3**

(22) Anmeldetag: **10.12.2009**

(54) **Verfahren und Vorrichtung zur Bestimmung einer Winkellage mittels eines Resolvers**

Method and device for determining an angular position by means of a resolver

Procédé et dispositif de détermination d'une position angulaire au moyen d'un résolveur

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **21.01.2009 DE 102009005494**

(43) Veröffentlichungstag der Anmeldung:
**28.07.2010 Patentblatt 2010/30**

(73) Patentinhaber: **KUKA Laboratories GmbH 86165 Augsburg (DE)**

(72) Erfinder: **Steidl, Dietmar 86163 Augsburg (DE)**

(74) Vertreter: **Schlotter, Alexander Carolus Paul et al Wallinger Ricker Schlotter Tostmann Patent- und Rechtsanwälte Zweibrückenstrasse 5-7 80331 München (DE)**

(56) Entgegenhaltungen:
**EP-A2- 1 498 698     US-A- 5 684 719**

- **KAUL ET AL: "Improving the accuracy of low-cost resolver-based encoders using harmonic analysis", NUCLEAR INSTRUMENTS & METHODS IN PHYSICS RESEARCH, SECTION - A:ACCELERATORS, SPECTROMETERS, DETECTORS AND ASSOCIATED EQUIPMENT, ELSEVIER, AMSTERDAM, NL, Bd. 586, Nr. 2, 7. Januar 2008 (2008-01-07), Seiten 345-355, XP022457702, ISSN: 0168-9002**

**Beschreibung**

Die vorliegende Erfindung betrifft ein Verfahren und eine Vorrichtung zur Bestimmung einer Winkellage mittels eines Resolvers, insbesondere bei hohen Drehzahlen.

Resolver werden in der Technik unter anderem zur Erfassung der Winkellage von aktuierten oder nicht aktuierten Drehgelenken, Motoren und dergleichen verwendet. In der Robotik kommt der Auswertung der Resolver-Signale eine besondere Bedeutung zu, da sie entscheidend das Fahrverhalten und die Positioniergenauigkeit des Roboters beeinflussen.

In einer bekannten Bauweise eines Resolvers umfasst dieser zwei um 90° versetzte Statorwicklungen, die einen drehbar gelagerten Rotor mit einer Rotorwicklung umschließen. Die vorliegende Erfindung ist gleichermaßen auch bei anderen Resolver-Bauweisen einsetzbar, wenn etwa im Rotor zwei zueinander versetzte Wicklungen angeordnet und durch eine Statorwicklung erregt werden, oder bei einem Resolver mit variablem magnetischem Widerstand, wie er aus der EP 0 877 464 A2 bekannt geworden ist. Insoweit dienen die Ausführungen zum Resolver nur dem besseren Verständnis.

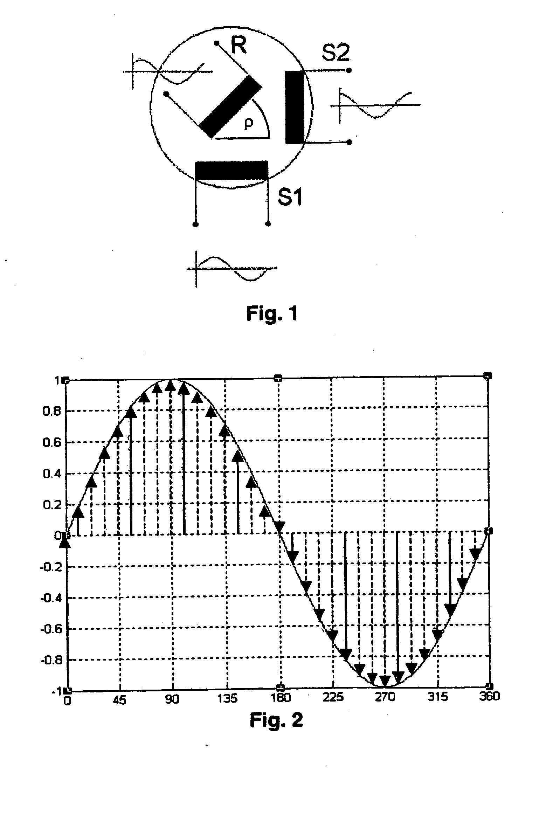

Der Rotor des Resolvers wird durch ein Referenz-Sinussignal der Form $U(t) = U_R \cdot \sin(2\pi \cdot f \cdot t)$ mit der Amplitude $U_R$ und der Frequenz $f$ erregt, das in den Statorwicklungen S1 und S2 - je nach Rotorstellung - Spannungen unterschiedlicher Amplitude induziert. Bezeichne $\rho$ den wie in Fig. 1 dargestellt definierten Winkel des Rotors, so ergibt sich für S1 die Spannung

$$U_{S1}(t) = C_{TF} \cdot U_R \cdot \sin(2\pi \cdot f \cdot t + \varphi_R) \cdot \cos\rho = U_{S1,Amp} \cdot \sin(2\pi \cdot f \cdot t + \varphi_R), \quad (1)$$

sowie für S2 die Spannung

$$U_{S2}(t) = C_{TF} \cdot U_R \cdot \sin(2\pi \cdot f \cdot t + \varphi_R) \cdot \sin\rho = U_{S2,Amp} \cdot \sin(2\pi \cdot f \cdot t + \varphi_R). \quad (2)$$

Die beiden induzierten Spannungen sind also theoretisch in Frequenz $f$ und Phase identisch, können aber in der Phase um $\varphi_R$ gegenüber dem Referenzsinus verschoben sein, mit dem die Rotorwicklung erregt wird, wobei $C_{TF}$ den Übertragungsfaktor bezeichnet. Der Winkel $\rho$ des Resolvers lässt sich also durch

$$\rho = \arctan\left(\frac{C_{TF} \cdot U_R \cdot \sin\rho}{C_{TF} \cdot U_R \cdot \cos\rho}\right) = \arctan\left(\frac{U_{S2,Amp}}{U_{S1,Amp}}\right) \quad (3)$$

bestimmen.

Wichtig für ein gutes Positionssignal ist also eine möglichst genaue Bestimmung der Amplituden $U_{S1,Amp}$ und $U_{S2,Amp}$.

Neben der herkömmlichen Abtastung der Spannungen $U_{S1}(t)$, $U_{S2}(t)$ im Bereich ihrer Extrema, in denen $U_S(t) \approx U_{S,Amp}$ gilt, die jedoch aufgrund der Sensitivität bezüglich des Abtastzeitpunktes Schwierigkeiten bereitet, ist es beispielsweise aus der US 5,241,268 bereits bekannt, eine Fourier-Transformation der Spannungen $U_{S1}(t)$, $U_{S2}(t)$ durchzuführen, um die Amplituden $U_{S1,Amp}$ und $U_{S2,Amp}$ und somit den Rotorwinkel $\rho$ zuverlässiger und präziser zu bestimmen.

Die US 5 684 719 A offenbart einen softwarebasierten Resolver zur Erfassung eines Drehwinkels in einem kardanischen Instrument. Die Signale des Resolvers samt des Referenzsignals werden dabei zunächst durch einen Multiplexer geleitet, digitalisiert und einem Prozessor zugeführt. Der Prozessor filtert die Eingangssignale und berechnet über eine schnelle Fourier Transformation (FFT) die Werte des Drehwinkels.

Die EP 1 498 698 A2 schlägt ein Verfahren vor um die Genauigkeit eines statisch kompensierten Resolvers weiter zu erhöhen, indem zusätzlich eine dynamische Fehlerkompensation angewendet wird. Der statische Fehler ist dabei definiert als eine Abweichung des Rotors von einer Referenzposition im Stillstand. Der dynamische Fehler ist dabei definiert als eine Abweichung des Rotors von einer Referenzposition während einer Rotationsbewegung.

Hierzu werden die Spannungssignale $U_{S1}(t)$, $U_{S2}(t)$ äquidistant abgetastet. Die Berechnung der Amplitude dieser N zeitdiskreten Abtastwerte erfolgt dann beispielsweise mittels der diskreten Fourier- Transformation, die ein Zeitsignal in den Frequenzbereich überführt. Die komplexen Fourierkoeffizienten $\hat{a} = (\hat{a}_0, ..., \hat{a}_{N-1})$ berechnen sich aus den zeitdiskreten Abtastwerten $a = (a_0, ..., a_{N-1})$ gemäß:

$$\hat{a}_k = \frac{1}{N} \sum_{j=0}^{N-1} e^{-i2\pi\frac{jk}{N}} \cdot a_j \quad \text{für } k=0, ..., N-1 \qquad (4)$$

Der Fourierkoeffizient $\hat{a}_k$ bei der Frequenz des Resolversignals enthält die Amplitude $2\cdot|\hat{a}_k|$ sowie die Phase $\angle(\hat{a}_k)$ des abgetasteten Signals. Welcher der Koeffizienten dem Erregersignal entspricht, hängt von der Anzahl der Vollwellen ab, über die man die Fourier-Transformation rechnet. Ist es eine Vollwelle, so wird beispielsweise der erste Koeffizient berechnet und Gleichung (4) vereinfacht sich zu:

$$\hat{a}_1 = \frac{1}{N} \sum_{j=0}^{N-1} e^{-i2\pi\frac{j}{N}} \cdot a_j \qquad (5)$$

Bei zwei Vollwellen wird entsprechend der zweite Koeffizient berechnet, bei drei Vollwellen der dritte Koeffizient usw..

Gleichung (5) kann mit Hilfe der Euler-Formel $e^{i\theta} = \cos\theta + i\sin\theta$ auch mit getrenntem Real- und Imaginär-Teil dargestellt werden:

$$\hat{a}_1 = \frac{1}{N} \sum_{j=0}^{N-1} \cos(2\pi \cdot j/N) \cdot a_j - i\frac{1}{N} \sum_{j=0}^{N-1} \sin(2\pi \cdot j/N) \cdot a_j \qquad (6)$$

Der Fourier-Koeffizient aus Gleichung (6) ist sowohl für $U_{S1}(t)$ und $U_{S2}(t)$ zu berechnen.

Zur Lösung von Gleichung (3) kann mit einer komplexen Division

$$\frac{z_{S1}}{z_{S2}} = \frac{\hat{a}_{1,S1}}{\hat{a}_{1,S2}} = \frac{x_{S1} + iy_{S1}}{x_{S2} + iy_{S2}} = \frac{x_{S1}x_{S2} + y_{S1}y_{S2}}{x_{S2}^2 + y_{S2}^2} + i\frac{x_{S2}y_{S1} - x_{S1}y_{S2}}{x_{S2}^2 + y_{S2}^2} \qquad (7)$$

der beiden (komplexen) Fourierkoeffizient $z_{S1}$, $z_{S2}$ gerechnet werden, die sich für die beiden Spannungssignale $U_{S1}(t)$, $U_{S2}(t)$ ergeben. Der Betrag dieser komplexen Zahl, i.e. der Realteil nach Gleichung (7) entspricht dem in Gleichung (3) einzusetzenden Quotienten der Amplituden.

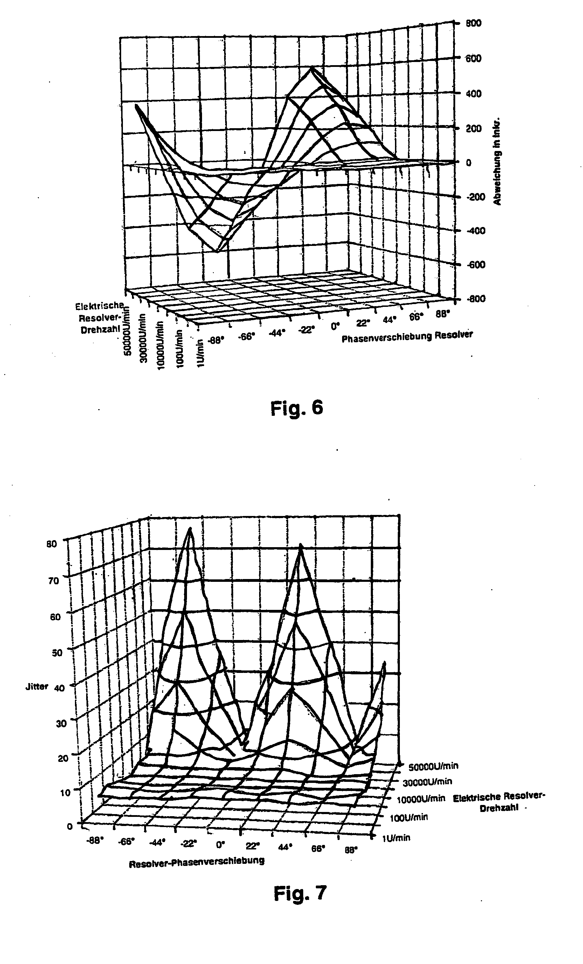

Nachteilig wird die ermittelte Position jedoch mit steigender Rotordrehzahl immer ungenauer. Es hat sich gezeigt, dass die gemittelte Abweichung in etwa linear abhängig von der Drehzahl und etwa sinusförmig bezüglich der Phasenverschiebung des Resolvers ist, wie dies in Fig. 6 dargestellt ist, in der die Abweichung in Inkrementen über der Phasenverschiebung des Resolvers (zunehmend von links nach rechts in Fig. 6) und der Drehzahl des Resolvers (zunehmend von vorne nach hinten in Fig. 6) aufgetragen ist. Zusätzlich zu dieser Positionsabweichung erhöht sich auch massiv der Jitter der Position, wie dies exemplarisch in Fig. 7 dargestellt ist, in der Peak- to- Peak- Werte des Jitters über der Phasenverschiebung des Resolvers (zunehmend von links nach rechts in Fig. 7) und der Drehzahl des Resolvers (zunehmend von vorne nach hinten in Fig. 7) aufgetragen sind.

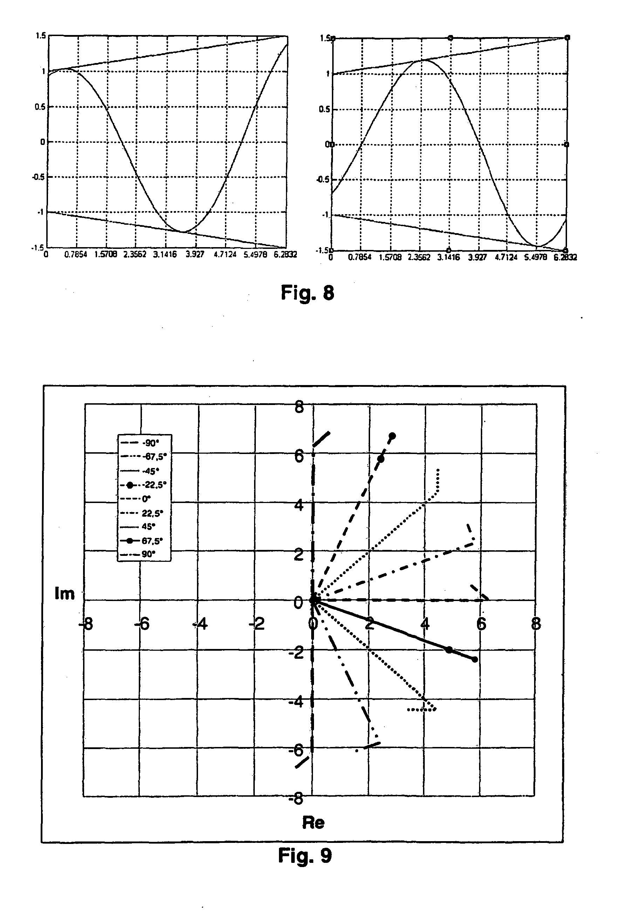

Dieser Effekt beruht nach Erkenntnissen des Erfinders im Wesentlichen darauf, dass sich die Position des Rotors innerhalb eines Fourier-Intervalls bei hohen Motordrehzahlen stark ändert. Dadurch entsteht eine große Änderung der Amplitude der Hüllkurve, die zur Bestimmung der Amplituden abgetastet wird. Fig. 8 zeigt zur Verdeutlichung zwei Signale, die in der Phase verschoben sind, jedoch dieselbe Hüllkurve besitzen. Daraus ist erkennbar, dass das Sinussignal die Hüllkurve sozusagen gewichtet. Das heißt, Amplitudenwerte der Hüllkurve an den Extremstellen des Sinus werden bei der Berechnung stärker gewichtet als andere Werte. An den Nullstellen hingegen kann die Amplitude der Hüllkurve gar nicht ausgewertet werden. Diese Gewichtung bewirkt, dass man bei der Fourier-Transformation nicht die Amplitude der Hüllkurve in der Mitte des Fourier-Intervalls erhält, sondern zu einem etwas nach links oder rechts verschobenen Zeitpunkt.

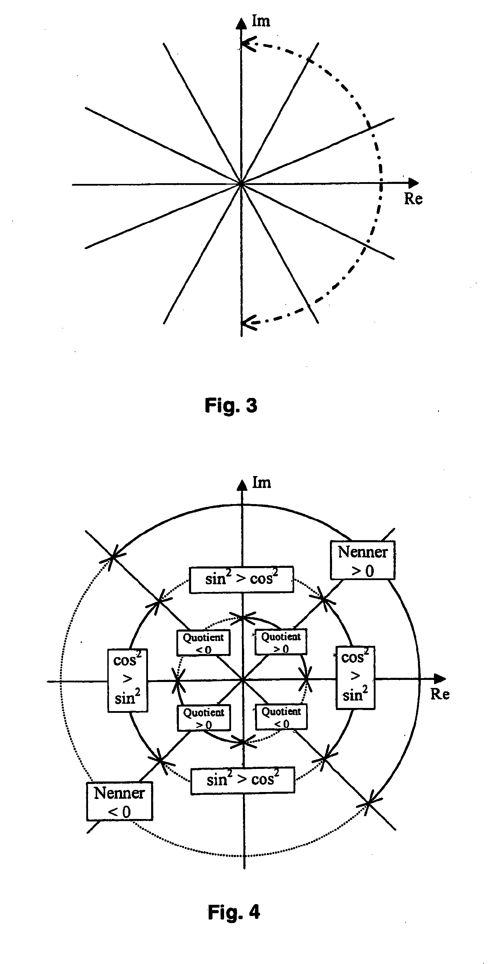

Da zusätzlich die Berechnung nach Gleichung (7) davon ausgeht, dass die theoretisch identischen Phasen sich im Wesentlichen eliminieren, ergibt sich eine weitere Verfälschung der Winkellage, da sich die Phasenlagen der Fourier-Koeffizienten durch die starke Änderung der Hüllkurve während eines Abtastintervalls verschieben. Sie liegen damit nicht mehr auf einer der Geraden aus Fig. 3 und verursachen folglich eine Abweichung.

Dementsprechend zeigt sich in den Fig. 6, 7 bei steigender Drehzahl, also einer größeren Änderung der Winkellage, und bei größeren Phasenverschiebungen des Resolvers eine zunehmende Positionsabweichung bzw. zunehmender Jitter.

Aufgabe der vorliegenden Erfindung ist es daher, insbesondere auch bei höheren Drehzahlen eine präzisere Erfassung der Winkellage eines Resolvers zu ermöglichen.

Diese Aufgabe wird durch ein Verfahren mit den Merkmalen des Anspruchs 1 bzw. eine Vorrichtung mit den Merkmalen des Anspruchs 11 gelöst. Vorteilhafte Weiterbildungen sind Gegenstand der Unteransprüche.

Erfindungsgemäß erfolgt die Bestimmung der Winkellage des Resolvers mit folgenden Schritten: eine Erregerwicklung, beispielsweise eine Rotorwicklung, wird mit einem, insbesondere periodischen, Referenzsignal erregt. Ein aus dem Referenzsignal resultierendes, insbesondere induziertes, erstes Signal in einer ersten Wicklung, beispielsweise einer ersten Statorwicklung, und ein aus dem Referenzsignal resultierendes, insbesondere induziertes, zweites Signal in einer zweiten Wicklung, beispielsweise einer zweiten Statorwicklung werden abgetastet. Hieraus werden zunächst unkompensierte Fourierkoeffizienten für das erste und das zweite Signal bestimmt.

Bevor nun die Winkellage des Resolvers aus den Fourierkoeffizienten für das erste und für das zweite Signal bestimmt wird, werden die Fourierkoeffizienten derart kompensiert, dass die Änderung der Fourierkoeffizienten der abgetasteten Hüllkurven des ersten und zweiten Signals aufgrund der Phasenverschiebung des Resolvers und/oder der Änderung der Winkellage während der Abtastung im Wesentlichen kompensiert werden.

Betrachtet man ohne Beschränkung der Allgemeinheit den Fall von N Abtastungen pro Vollwelle und nimmt vereinfachend als Hüllkurve eine Gerade an, so lässt sich die in Fig. 8 dargestellte Kurve durch

$$y = \left( t + m\left( x + \frac{1}{N}\pi \right) \right) \cdot \cos(x + x_c) \tag{8}$$

beschreiben, wobei $t$ die Amplitude bei $-\pi/N$, m die Steigung der Hüllkurve und $x_c$ die Phasenverschiebung des Resolvers bezeichnet. Wendet man auf diese Funktion die Fourier-Transformation an, so ist zur Bestimmung des für die Quotientenbildung nach Gleichung (3) erforderlichen Fourierkoeffizienten das Integral

$$\frac{1}{2\pi} \int_{-\frac{\pi}{N}}^{2\pi-\frac{\pi}{N}} \left( t + m\left( x + \frac{1}{N}\pi \right) \right) \cdot \cos(x + x_c) \cdot e^{-ix} dx \tag{9}$$

zu lösen. Die Grenzen des Integrals sind um $-\pi/N$ verschoben, da die Werte der diskreten Fourier-Transformation nicht symmetrisch um $\pi$, sondern bei N Koeffizienten um $\left( 1 - \frac{1}{N} \right) \cdot \pi$ verteilt sind. Mithilfe der Euler-Formel $\cos\theta = \frac{1}{2}\left( e^{i\theta} + e^{-i\theta} \right)$ lässt sich Gleichung (9) umformen zu:

$$\frac{1}{2\pi} \int_{-\frac{\pi}{N}}^{2\pi-\frac{\pi}{N}} \left( t+m\left( x+\frac{1}{N}\pi \right) \right) \cdot \frac{1}{2}\left( e^{i(x+x_c)} + e^{-i(x+x_c)} \right) \cdot e^{-ix} dx$$

$$= \frac{1}{4\pi} \int_{-\frac{\pi}{N}}^{2\pi-\frac{\pi}{N}} \left( \left( t+\frac{m\pi}{N} \right) + mx \right) \cdot \left( e^{ix_c} + e^{-i(2x+x_c)} \right) dx \qquad (10)$$

Zur Lösung dieser Gleichung (10) sind vier Integrale zu lösen (zur besseren Lesbarkeit wird die Konstante

$t + \frac{m\pi}{N}$ mit $t_0$ abgekürzt):

$$\frac{1}{4\pi}\left[ \int_{-\frac{\pi}{N}}^{2\pi-\frac{\pi}{N}} t_0 \cdot e^{ix} dx + \int_{-\frac{\pi}{N}}^{2\pi-\frac{\pi}{N}} mx \cdot e^{ix} dx + \int_{-\frac{\pi}{N}}^{2\pi-\frac{\pi}{N}} t_0 \cdot e^{-i(2x+x_c)} dx + \int_{-\frac{\pi}{N}}^{2\pi-\frac{\pi}{N}} mx \cdot e^{-i(2x+x_c)} dx \right] \qquad (11)$$

Die Nebenrechnung

$$1. \quad \int_{-\frac{\pi}{N}}^{2\pi-\frac{\pi}{N}} t_0 \cdot e^{ix_c} dx = t_0 \cdot e^{ix_c} \int_{-\frac{\pi}{N}}^{2\pi-\frac{\pi}{N}} 1 dx = 2\pi t_0 \cdot e^{ix_c}$$

$$2. \quad \int_{-\frac{\pi}{N}}^{2\pi-\frac{\pi}{N}} mx \cdot e^{ix_c} dx = m \cdot e^{ix_c} \int_{-\frac{\pi}{N}}^{2\pi-\frac{\pi}{N}} x dx = m \cdot e^{ix_c} \left[ \frac{1}{2}x^2 \right]_{-\frac{\pi}{N}}^{2\pi-\frac{\pi}{N}} = \left( 1 - \frac{1}{N} \right) \cdot 2\pi^2 m \cdot e^{ix_c}$$

$$3. \quad \int_{-\frac{\pi}{N}}^{2\pi-\frac{\pi}{N}} t_0 \cdot e^{-i(2x+x_c)} dx = t_0 \cdot e^{-ix_c} \int_{-\frac{\pi}{N}}^{2\pi-\frac{\pi}{N}} e^{-2ix} dx = t_0 \cdot e^{-ix_c} \cdot \left[ \frac{1}{-2ix} e^{-2ix} \right]_{-\frac{\pi}{N}}^{2\pi-\frac{\pi}{N}} = 0$$

$$4. \quad \int_{-\frac{\pi}{N}}^{2\pi-\frac{\pi}{N}} mx \cdot e^{-i(2x+x_c)}dx = m \cdot e^{-ix_c} \int_{-\frac{\pi}{N}}^{2\pi-\frac{\pi}{N}} x \cdot e^{-2ix}dx = m \cdot e^{-ix_c}\left[\frac{e^{-2ix}}{(-2i)^2}(-2ix-1)\right]_{-\frac{\pi}{N}}^{2\pi-\frac{\pi}{N}} =$$

$$= m \cdot e^{-ix_c}\left[\frac{e^{-2ix}}{4}(2ix+1)\right]_{-\frac{\pi}{N}}^{2\pi-\frac{\pi}{N}} = m \cdot e^{-ix_c}e^{i\frac{2\pi}{N}}i\left[\frac{x}{2}\right]_{-\frac{\pi}{N}}^{2\pi-\frac{\pi}{N}} = m\pi \cdot e^{i\left(\left(\frac{2}{N}+\frac{1}{2}\right)\pi - x_c\right)}$$

führt, eingesetzt in Gleichung (11), auf:

$$\frac{1}{4\pi}\left[2\pi t_0 \cdot e^{ix_c} + \left(1-\frac{1}{N}\right) \cdot 2\pi^2 m \cdot e^{ix_c} + 0 + m\pi \cdot e^{i\left(\left(\frac{2}{N}+\frac{1}{2}\right)\pi - x_c\right)}\right] =$$

$$= \frac{1}{2}\left(t_0 + \left(1-\frac{1}{N}\right) \cdot \pi m\right) \cdot e^{ix_c} + \frac{1}{4}m \cdot e^{i\left(\left(\frac{2}{N}+\frac{1}{2}\right)\pi - x_c\right)} =$$

$$= \frac{1}{2}\left(t + \pi m\right) \cdot e^{ix_c} + \frac{1}{4}m \cdot e^{i\left(\left(\frac{2}{N}+\frac{1}{2}\right)\pi - x_c\right)} \tag{12}$$

Der erste Term $\frac{1}{2}\left(t + \pi m\right) \cdot e^{ix_c}$ in Gleichung (12) ist der gewünschte Anteil, die Phase dieser komplexen Zahl entspricht der Phasenlage des Resolvers. Der Betrag entspricht der halben Amplitude der Hüllkurve bei $\left(1-\frac{1}{N}\right) \cdot \pi$. Der Faktor ½ resultiert aus der Tatsache, dass ein Kosinus-Signal je einen halben Anteil bei der Frequenz f und bei -f hat. Das lässt sich beispielsweise auch an der Euler-Formel $\cos\theta = \frac{1}{2}\left(e^{i\theta} + e^{-i\theta}\right)$,

Der zweite Term $\frac{1}{4}m \cdot e^{i\left(\left(\frac{2}{N}+\frac{1}{2}\right)\pi - x_c\right)}$ in Gleichung (12) ist verantwortlich für die unerwünschte Abweichung. Er bewirkt zum einen, dass die in Fig. 3 dargestellten, nachfolgend näher erläuterten Geraden zu Ellipsen degenerieren, die sich mit steigender Drehzahl immer weiter öffnen. Dadurch erhöht sich der Jitter (vgl. Fig. 7), da die Auswertung von Gleichung (7) darauf basiert, dass die Phasenlage von S1 und S2 identisch sind. Durch diese Verschiebung der Phasenlage der Fourierkoeffizienten dreht sich der komplexe Quotient gemäß Gleichung (7) aus der 0°-Lage und weist einen Imaginärteil auf, der bei der Auswertung der Gleichung (7) vernachlässigt wird. Zum anderen ändert der zweite Term in Gleichung (12) den Betrag des Fourierkoeffizienten und führt damit zur in Fig. 6 dargestellten Positionsabweichung.

In Gleichung (12) entspricht der Term $\frac{1}{2}t \cdot e^{ix_c}$ dem korrekten Fourierkoeffizienten einer Halbwelle vorher, d.h. einem Fourierkoeffizienten einer Halbwelle vorher, bei dem die Abweichung kompensiert ist. Bildet man also die Differenz des unkompensierten neuen Fourierkoeffizienten und des bereits kompensierten alten, so erhält man:

$$\frac{1}{2}\pi m \cdot e^{ix_c} + \frac{1}{4}m \cdot e^{i\left(\left(\frac{2}{N}+\frac{1}{2}\right)\pi-x_c\right)} \tag{13}$$

Der Betrag des gewünschten Anteils der Differenz ist also genau um $\frac{1}{2}\pi m \cdot \Big/ \frac{1}{4}m \cdot = \cdot 2\pi$ größer als der Betrag der Abweichung. Der Winkel der Abweichung beträgt bei N=8 zum Beispiel 135°-$x_c$, geht also bei +67,5° genau in Richtung des Nutzsignal und bei -22,5° entgegengesetzt. Bei +22,5° und -67,5° steht die Abweichung senkrecht auf dem Nutzsignal. Fig. 9 zeigt hierzu exemplarisch die Richtung von Nutzanteil und Abweichung für verschiedene Resolver-Phasenverschiebungen bei N=8.

Dreht man die komplexe Zahl gemäß Gleichung (13) in der Zahlenebene um $\pi/N$ im Uhrzeigersinn, was einer Multiplikation mit $e^{-i\frac{\pi}{N}}$ entspricht, so erhält man:

$$\frac{1}{2}\pi m \cdot e^{i\left(x_c-\frac{\pi}{N}\right)} + \frac{1}{4}m \cdot e^{i\left(\frac{1}{2}\pi-\left(x_c-\frac{\pi}{N}\right)\right)} \tag{14}$$

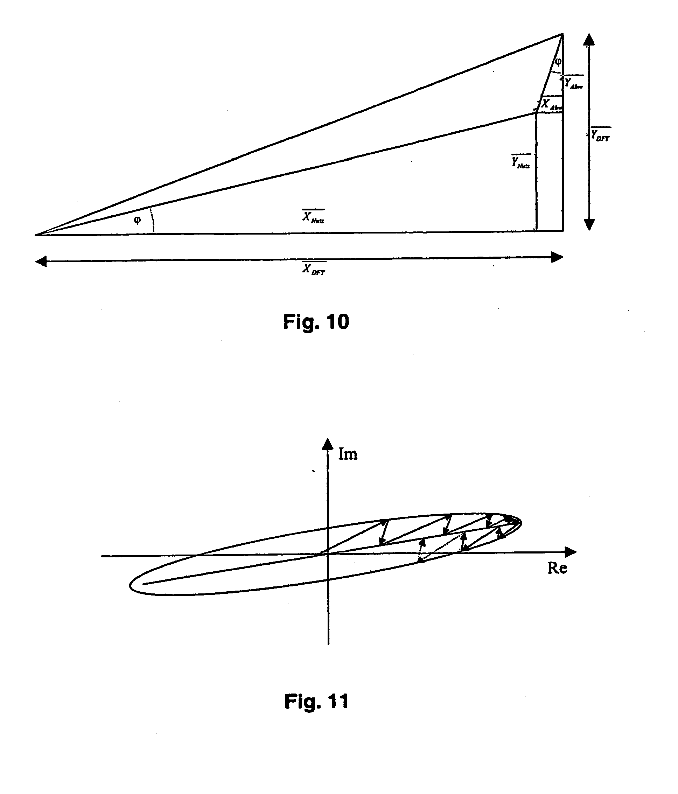

Aus dieser Summe lässt sich die Abweichung bestimmen. Fig. 10 zeigt hierzu eine Skizze zur Verdeutlichung, wobei hier $x_c - \frac{\pi}{N}$ mit φ abgekürzt ist. Da die Abweichung den Winkel 90°-φ hat, taucht der Winkel auch in dem rechten, oberen kleinen Dreieck in Fig. 10 auf. Daher gilt:

$$\overline{X_{Nutz}} = 2\pi \cdot \overline{Y_{Abw}} \text{, sowie } \overline{Y_{Nutz}} = 2\pi \cdot \overline{X_{Abw}} \tag{15}$$

Die bekannten Größen $\overline{X_{DFT}}$ und $\overline{Y_{DFT}}$ lassen sich also ausdrücken durch:
Das ist ein lineares Gleichungssystem. Mit $\overline{X_{Abw}} = \overline{X_{DFT}} - 2\pi \cdot \overline{Y_{Abw}}$ und $\overline{Y_{ABw}} = \overline{Y_{DFT}} - 2\pi \cdot \overline{X_{Abw}}$ folgt

$$\overline{X_{DFT}} = \overline{X_{Abw}} + 2\pi \cdot \left(\overline{Y_{DFT}} - 2\pi \cdot \overline{X_{Abw}}\right) \quad \Rightarrow \quad \overline{X_{Abw}} = \frac{2\pi \cdot \overline{Y_{DFT}} - \overline{X_{DFT}}}{4\pi^2 - 1}$$

$$\overline{Y_{DFT}} = \overline{Y_{Abw}} + 2\pi \cdot \left(\overline{X_{DFT}} - 2\pi \cdot \overline{Y_{Abw}}\right) \quad \Rightarrow \quad \overline{Y_{Abw}} = \frac{2\pi \cdot \overline{X_{DFT}} - \overline{Y_{DFT}}}{4\pi^2 - 1} \qquad (17)$$

Danach muss die Abweichung wieder um $\pi/N$ gegen den Uhrzeigersinn zurückgedreht werden. Diese drei Schritte lassen sich vorteilhaft zusammenfassen. Sei $X_{DFT} + i \cdot Y_{DFT}$ die Differenz des unkompensierten neuen Fourierkoeffizienten und des bereits kompensierten alten, so erhält man durch Drehung mit $e^{-i\frac{\pi}{N}}$ :

$$\overline{X_{DFT}} + i \cdot \overline{Y_{DFT}} = \left(X_{DFT} + i \cdot Y_{DFT}\right) \cdot e^{-i\frac{\pi}{N}} = \left(X_{DFT} + i \cdot Y_{DFT}\right) \cdot \left(\cos\frac{\pi}{N} - i \cdot \sin\frac{\pi}{N}\right)$$

$$\overline{X_{DFT}} = X_{DFT} \cdot \cos\frac{\pi}{N} + Y_{DFT} \cdot \sin\frac{\pi}{N}$$

$$\overline{Y_{DFT}} = Y_{DFT} \cdot \cos\frac{\pi}{N} - X_{DFT} \cdot \sin\frac{\pi}{N} \qquad (18)$$

Eingesetzt in Gleichung (17) ergibt sich:

$$\overline{X_{Abw}} = \frac{2\pi \cdot \left(Y_{DFT} \cdot \cos\frac{\pi}{N} - X_{DFT} \cdot \sin\frac{\pi}{N}\right) - \left(X_{DFT} \cdot \cos\frac{\pi}{N} + Y_{DFT} \cdot \sin\frac{\pi}{N}\right)}{4\pi^2 - 1} =$$

$$= \frac{\left(2\pi \cdot \cos\frac{\pi}{N} - \sin\frac{\pi}{N}\right) \cdot Y_{DFT} - \left(2\pi \cdot \sin\frac{\pi}{N} + \cos\frac{\pi}{N}\right) \cdot X_{DFT}}{4\pi^2 - 1}$$

$$\overline{Y_{Abw}} = \frac{2\pi \cdot \left(X_{DFT} \cdot \cos\frac{\pi}{N} + Y_{DFT} \cdot \sin\frac{\pi}{N}\right) - \left(Y_{DFT} \cdot \cos\frac{\pi}{N} - X_{DFT} \cdot \sin\frac{\pi}{N}\right)}{4\pi^2 - 1} =$$

$$= \frac{\left(2\pi \cdot \cos\frac{\pi}{N} + \sin\frac{\pi}{N}\right) \cdot X_{DFT} + \left(2\pi \cdot \sin\frac{\pi}{N} - \cos\frac{\pi}{N}\right) \cdot Y_{DFT}}{4\pi^2 - 1} \qquad (19)$$

Zurückdrehen dieser Abweichung erfolgt durch Multiplikation mit $e^{i\frac{\pi}{N}}$ :

$$X_{Abw} + i \cdot Y_{Abw} = \left(\overline{X_{Abw}} + i \cdot \overline{Y_{Abw}}\right) \cdot e^{i\frac{\pi}{N}} = \left(\overline{X_{Abw}} + i \cdot \overline{Y_{Abw}}\right) \cdot \left(\cos\frac{\pi}{N} + i \cdot \sin\frac{\pi}{N}\right)$$

$$X_{Abw} = \overline{X_{Abw}} \cdot \cos\frac{\pi}{N} - \overline{Y_{Abw}} \cdot \sin\frac{\pi}{N}$$

$$Y_{Abw} = \overline{Y_{Abw}} \cdot \cos\frac{\pi}{N} + \overline{X_{Abw}} \cdot \sin\frac{\pi}{N} \qquad (20)$$

Mit Gleichung (19) ergibt sich:

$$X_{Abw} = \frac{\left(2\pi \cdot \cos\frac{\pi}{N} - \sin\frac{\pi}{N}\right) \cdot Y_{DFT} - \left(2\pi \cdot \sin\frac{\pi}{N} + \cos\frac{\pi}{N}\right) \cdot X_{DFT}}{4\pi^2 - 1} \cdot \cos\frac{\pi}{N}$$

$$-\frac{\left(2\pi\cdot\cos\frac{\pi}{N}+\sin\frac{\pi}{N}\right)\cdot X_{DFT}+\left(2\pi\cdot\sin\frac{\pi}{N}-\cos\frac{\pi}{N}\right)\cdot Y_{DFT}}{4\pi^2-1}\cdot\sin\frac{\pi}{N}=$$

$$=\frac{2\pi\cdot\left(\cos^2\frac{\pi}{N}-\sin^2\frac{\pi}{N}\right)\cdot Y_{DFT}-\left(4\pi\cdot\sin\frac{\pi}{N}\cdot\cos\frac{\pi}{N}+1\right)\cdot X_{DFT}}{4\pi^2-1}=$$

$$=\frac{2\pi\cdot\cos\frac{2\pi}{N}\cdot Y_{DFT}-\left(2\pi\cdot\sin\frac{2\pi}{N}+1\right)\cdot X_{DFT}}{4\pi^2-1}$$

$$Y_{Abw}=\frac{\left(2\pi\cdot\cos\frac{\pi}{N}+\sin\frac{\pi}{N}\right)\cdot X_{DFT}+\left(2\pi\cdot\sin\frac{\pi}{N}-\cos\frac{\pi}{N}\right)\cdot Y_{DFT}}{4\pi^2-1}\cdot\cos\frac{\pi}{N}$$

$$+\frac{\left(2\pi\cdot\cos\frac{\pi}{N}-\sin\frac{\pi}{N}\right)\cdot Y_{DFT}-\left(2\pi\cdot\sin\frac{\pi}{N}+\cos\frac{\pi}{N}\right)\cdot X_{DFT}}{4\pi^2-1}\cdot\sin\frac{\pi}{N}=$$

$$=\frac{2\pi\cdot\left(\cos^2\frac{\pi}{N}-\sin^2\frac{\pi}{N}\right)\cdot X_{DFT}+\left(4\pi\cdot\sin\frac{\pi}{N}\cdot\cos\frac{\pi}{N}-1\right)\cdot Y_{DFT}}{4\pi^2-1}$$

$$=\frac{2\pi\cdot\cos\frac{2\pi}{N}\cdot X_{DFT}+\left(2\pi\cdot\sin\frac{2\pi}{N}-1\right)\cdot Y_{DFT}}{4\pi^2-1} \tag{21}$$

Außer $X_{DFT}$ und $Y_{DFT}$ handelt es sich hierbei nur um Konstanten. Die Berechnung gestaltet sich somit vorteilhaft einfach. Fig. 11 zeigt schematisch die Funktionsweise der Kompensation.

Die Ellipse stellt die unkompensierten Werte dar, die Gerade die kompensierten. Gleichung (21) ergibt nun aus den von der Geraden ausgehenden Differenzvektoren die zur Geraden zurückführenden Korrekturvektoren.

Erfindungsgemäß werden daher die aktuellen Fourierkoeffizienten, die sich aus der Abtastung ergeben, mit komplexen Kompensationsvektoren mit Real- und Imaginärteilen gemäß Gleichung (21) kompensiert, die sich aus der Differenz $X_{DFT}+i\cdot Y_{DFT}$ des jeweiligen aktuellen unkompensierten Fourierkoeffizienten und eines kompensierten Fourierkoeffizienten ergeben , der für einen vorhergehenden Abtastzeitraum, beispielsweise einer Halbwelle vorher oder einem Abtastwert vorher, bestimmt worden ist.

Wie der Vergleich der Fig. 3, 11 zeigt, wird durch das erfindungsgemäße Verfahren die aus der Veränderung der Rotorposition und der Abtastung der Hüllkurve der verschiedenen Rotorpositionen resultierende Abweichung kompensiert und der Fourierkoeffizient, aus dem die Winkellage ermittelt wird, auf die theoretische Gerade zurückgeführt.

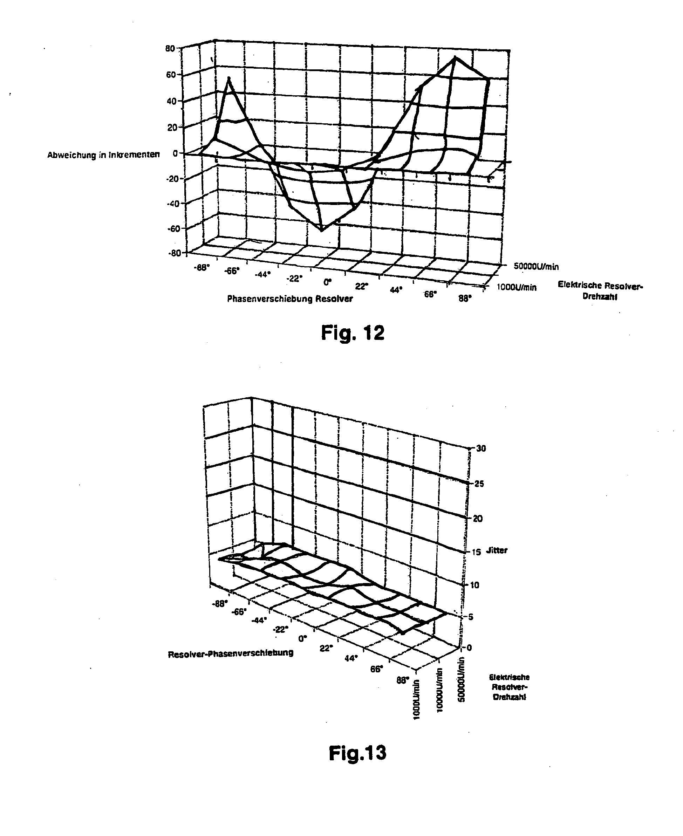

Fig. 12 und Fig. 13 zeigen in Fig. 6, 7 entsprechender Darstellung die Abweichung der Position (in Inkrementen) bzw. den Jitter (in Peak- to- Peak- Werten) über der Phasenverschiebung des Resolvers (zunehmend von links nach rechts in Fig. 12, 13) und der Drehzahl des Resolvers (zunehmend von vorne nach hinten in Fig. 12, 13) mit der erfindungsgemäßen Korrektur der Fourierkoeffizienten. Man erkennt, dass die Abweichung zwar nicht verschwunden, jedoch auf etwa 1/8 gesunken ist. Der Jitter ist sehr gut kompensiert und beträgt auch bei hohen Drehzahlen nicht mehr als im Stillstand.

Vorstehend wurde die erfindungsgemäße Kompensation der Änderung der unkompensierten Fourierkoeffizienten auf Basis einer linearen Hüllkurve erläutert. Gleichermaßen kann der Kompensation jedoch auch eine trigonometrische, insbesondere eine sinusförmige Hüllkurve zugrundegelegt werden, was zwar den Aufwand erhöht, jedoch die Hüllkurve genauer approximiert.

Vorteilhaft wird für das erste und zweite Signal ein kompensierter Fourierkoeffizient auf Basis der Differenz des unkompensierten Fourierkoeffizienten und eines kompensierten Fourierkoeffizienten bestimmt, der für einen vorhergehenden Abtastzeitraum bestimmt worden ist. Als Startwerte für ein erfindungsgemäßes Verfahren können beispielsweise Fourierkoeffizienten gewählt werden, die sich bei Abtastung bei noch stehendem Resolver und/oder ohne Phasenverschiebung ergeben.

Der vorhergehenden Abtastzeitraum kann das Ein- oder Mehrfache einer Abtastperiode, mit der das erste und zweite Signal abgetastet wird, umfassen, so dass eine erfindungsgemäße Kompensation insbesondere auch nach jedem Abtastwert durchgeführt werden kann, i.e. der zur Differenzbildung genutzte vorhergehenden Abtastzeitraum gerade dem Kehrwert der Frequenz der Abtastung entspricht.

Gleichermaßen kann, insbesondere um den Rechenaufwand zu verringern, der Abtastzeitraum eine halbe Periode des ersten und zweiten Signals umfassen, i.e. die erfindungsgemäße Kompensation nach einer Halbwelle durchgeführt werden.

Weitere Vorteile und Merkmale ergeben sich aus den Unteransprüchen und dem Ausführungsbeispiel. Hierzu zeigt, teilweise schematisiert:

Fig. 1:     einen Resolver;
Fig. 2:     die Abtastung eines Signals eines Resolver-Kanals zu diskreten äquidistanten Zeitpunkten;
Fig. 3:     die Lage von Fourierkoeffizienten für verschiedene Phasenverschiebungen des Resolvers aus Fig. 1;
Fig. 4:     Kriterien für die Oktanten-Bestimmung;
Fig. 5:     die Bestimmung der Winkellage im richtigen Oktanten;
Fig. 6:     Abweichung bei verschiedenen Resolver-Phasenverschiebungen und Drehzahlen;
Fig. 7:     Positionsjitter bei verschiedenen Resolver-Phasenverschiebungen und Drehzahlen;
Fig. 8:     Signale unterschiedlicher Phase mit identischer Hüllkurve;
Fig. 9:     Richtung von Nutzanteil und Abweichung für verschiedene Resolver-Phasenverschiebungen;
Fig. 10:    eine Skizze zur Berechnung der Kompensation;
Fig. 11:    eine erfindungsgemäße Kompensation;
Fig. 12:    Positionsabweichung nach einer erfindungsgemäßen Korrektur; und
Fig.13:     Positionsjitter nach einer erfindungsgemäßen Korrektur

Fig. 1 zeigt den prinzipiellen Aufbau eines Resolvers, dessen Winkellage gemäß einem Verfahren nach einer Ausführung der vorliegenden Erfindung bestimmt wird.

In einem zylindrischen Gehäuse sind zwei um 90° versetzte Statorwicklungen angeordnet, die einen im Gehäuse gelagerten Rotor mit der Rotorwicklung R umschließen. Dieser Rotor wird durch ein Referenz- Sinussignal $U(t) = U_R \cdot \sin(2\pi \cdot f \cdot t)$ gespeist, das in den Statorwicklungen S1 und S2- je nach Rotorstellung- Spannungen unterschiedlicher Amplitude induziert. Der Winkel $\rho$ des Resolvers lässt sich nach (3) durch

$$\rho = \arctan\left(\frac{\sin\rho}{\cos\rho}\right) = \arctan\left(\frac{U_{S2,Amp}}{U_{S1,Amp}}\right) \qquad (3)$$

bestimmen.

Gemäß des Verfahrens nach einer Ausführung der vorliegenden Erfindung werden die Amplitudensignale $U_{S1,Amp}$ und $U_{S2,Amp}$ äquidistant abgetastet, wie dies in Fig. 2 angedeutet ist. Zur Verdeutlichung sind in Fig. 2 zusätzlich die Abtastzeitpunkte von drei anderen Resolver-Kanälen gestrichelt eingezeichnet.

Vorteilhafterweise muss keiner der Abtastwerte tatsächlich das Maximum oder das Minimum des Signals treffen. Aufgrund des Nyquist-Shannonschen Abtasttheorems ist es vorteilhaft, das kontinuierliche, bandbegrenzte Signal mit einer Minimalfrequenz von 0 Hz und einer Maximalfrequenz $f_{max}$ mit einer Frequenz größer als $2 * f_{max}$ abzutasten, um aus dem so erhaltenen zeitdiskreten Signal das Ursprungssignal beliebig genau approximieren zu können. Durch die erreichbare Steilheit und den entsprechenden Aufwand im vorgeschalteten Anti-Aliasing-Filter ist es bevorzugt, mindestens mit 2,5* $f_{max}$ abzutasten. Im Ausführungsbeispiel entspricht diese Maximalfrequenz $f_{max}$ im Wesentlichen der Frequenz des Erregersignals.

Die Berechnung der Amplitude dieser zeitdiskreten Abtastwerte erfolgt mittels der diskreten Fourier-Transformation. Diese Transformation ist ein Spezialfall der z-Transformation mit Werten für z auf dem Einheitskreis. Im Ausführungsbeispiel wird, wie in Fig. 2 gezeigt, genau eine Vollwelle abgetastet, so dass nur der Koeffizient $\hat{a}_1$ gemäß Gleichung (6) berechnet werden muss. Alternativ können auch Mehrfache der Periode 1/f des Referenz-Sinussignals $U(t) = U_R \cdot \sin(2\pi \cdot f \cdot t)$ abgetastet werden.

Die Kosinus- und Sinus-Werte in Gleichung (6) sind für ein festes Abtastintervall und eine konstante Abtastfrequenz Konstanten und können im Programmcode in einer Tabelle hinterlegt sein. Die Berechnung eines Fourierkoeffizienten besteht damit vorteilhafterweise im Wesentlichen aus zwei Multiplikationen und zwei Additionen pro Abtastwert.

Zur Berechnung des Resolverwinkels werden die Amplituden der beiden Signale S1 und S2 benötigt. Es müssen also zwei komplexe Fourierkoeffizienten bestimmt werden.

Die Positionsbestimmung findet zunächst nur im ersten Oktanten, d.h. zwischen 0° und 45° statt. Negative Vorzeichen werden entfernt und für eine nachfolgend beschriebene Oktantenbestimmung gespeichert. Ist das Amplitudenquadrat von S2 größer als das von S1, i.e. der Winkel größer 45°, so werden die beiden Werte vertauscht und diese Information ebenfalls für die nachfolgend beschriebene Oktantenbestimmung gespeichert.

Zur Positionsberechnung wird nun eine trigonometrische Funktion angewendet, die in einem Prozessor bevorzugt über eine Tabelle mit linearer Interpolation implementiert ist. Der Tangens liegt im Bereich von 0° bis 45° relativ nahe an einer Geraden, lässt sich also gut linear interpolieren. Zur Berechnung der Gleichung (3) wird daher zunächst der Quotient der beiden Amplituden, also der Beträge der Fourierkoeffizienten gebildet. Um eine aufwendige und ungenaue Betragsbildung zu vermeiden, kann die Tatsache genutzt werden, dass S1 und S2 dieselbe Phasenlage besitzen. Es kann also mit der komplexen Division gemäß Gleichung (7) gerechnet werden, da sich hierbei die Beträge dividieren und die Phasen subtrahieren, also zu Null werden. Deshalb wird nur der Realteil von Gleichung (7) benötigt, der Imaginärteil sollte in etwa Null werden. Zur Erhöhung der Sicherheit kann der Zähler des Imaginärteils überprüft werden, er sollte nahezu Null betragen.

Der Nenner des Realteils entspricht der bereits berechneten quadrierten Amplitude. Da der Zähler immer kleiner oder gleich dem Nenner ist, liegt der Quotient zwischen 0 und 1 und eine Division durch Null kann nicht auftreten. Der berechnete Winkel liegt also zwischen 0° und 45°.

Um diesen Winkel auf einen Bereich von 0° bis 360° zu erweitern, wird nachfolgend bestimmt, in welchem der acht Oktanten sich der Rotor gerade befindet. Dazu sind im Prinzip drei Signale nötig, die in Kombination eine ausreichende Information tragen ($8 = 2^3$). Hierbei sollte sichergestellt werden, dass die Übergänge zwischen den Oktanten auf jeden Fall stetig, d.h. ohne Sprung stattfinden.

Prinzipiell kann die Information, in welchem der acht Oktanten sich der Rotor gerade befindet, beispielsweise aus dem Vorzeichen der Amplitude von S1, dem Vorzeichen der Amplitude von S2 und dem Vergleich der Amplitudenquadrate S1 und S2 bestimmt werden.

Bei der Bestimmung der Vorzeichen der Amplituden von S1 und S2 ist der erlaubte Bereich der Phasenverschiebung des Resolvers zu berücksichtigen. Da die Phasenverschiebung eines einzelnen Resolvers relativ konstant ist, liefert die Fouriertransformation Koeffizienten die sich alle auf einer Geraden durch den Ursprung befinden. Fig. 3 zeigt solche Geraden für Resolver mit verschiedenen Phasenverschiebungen. Bei der Umkehrung des Vorzeichens wandert der komplexe Koeffizient durch den Ursprung und erfährt hier einen Phasensprung von 180°.

Definiert man den erlaubten Bereich der Resolver-Phasenverschiebung auf -90° bis +90°, wie dies in Fig. 3 durch den strichpunktierten Doppelpfeil angedeutet ist, so kann das Vorzeichen der Amplitude einfach durch das Vorzeichen des Realteils des komplexen Koeffizienten bestimmt werden.

Problematisch sind allerdings Koeffizienten nahe dem Ursprung, speziell bei größeren Phasenverschiebungen. Hier kann durch Störungen und Rauschen der Koeffizient fälschlicherweise in den anderen Bereich kommen. Dies soll jedoch nicht zu Unstetigkeiten in der Positionsbestimmung führen.

Deshalb werden zur Oktantenbestimmung nicht die Vorzeichen von S1 und S2 direkt benutzt, sondern zum einen das Vorzeichen des Quotienten. Ist ein Koeffizient sehr klein, so ist der andere immer groß. Durch die komplexe Division dreht der große Koeffizienten den kleinen Koeffizienten aus dem problematischen Bereich. Das zweite Vorzeichen ergibt sich aus dem Nenner des Quotienten, da dieser immer größer als sin 45°, i.e. ungefähr 70% ist und eine zuverlässige Information bietet.

Dadurch können die acht Oktanten, wie in Fig. 4 angedeutet, unterschieden werden. Der Winkel wird somit in vier Schritten erweitert:

1. Ist der Quotient nach Gleichung (7) negativ, so wird das Vorzeichen des Winkels invertiert (-45° < Winkel < +45°).
2. Gilt $\sin^2 > \cos^2$, so wird die Differenz 90°-Winkel gebildet (-45° < Winkel < 135°).

3. Ist der Nenner des Quotienten negativ, so wird ein Winkel von 180° addiert (-45° < Winkel < 315°).

4. Die Differenz zur letzten Position wird gebildet und anschließend aufsummiert. Dadurch läuft der Winkel theoretisch endlos (oder bis der Datentyp überläuft).

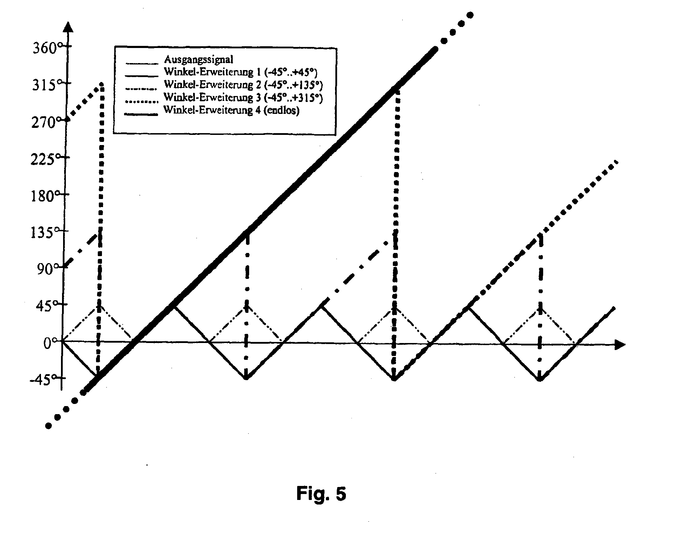

Fig. 5 zeigt die Winkel der Erweiterungsschritte für einen mit konstanter Drehzahl drehenden Resolver. Man sieht, dass erst beim dritten Erweiterungsschritt ein Sprung auftreten könnte. Dieser Erweiterungsschritt ist daher vorteilhafterweise nicht bei 180°, sondern bei 135° platziert, da hier für S1 und S2 mit etwa 70% Pegel die Invertierung der Phase sicher erkannt werden kann.

Gemäß Gleichung (21) werden aus der Differenz $X_{DFT} + i \cdot Y_{DFT}$ des unkompensierten aktuellen Fourier-Koeffizienten und des bereits kompensierten vorhergehenden Fourier-Koeffizienten Real- und Imaginärteil

$$X_{Abw} = \frac{2\pi \cdot \cos \frac{2\pi}{N} \cdot Y_{DFT} - \left(2\pi \cdot \sin \frac{2\pi}{N} + 1\right) \cdot X_{DFT}}{4\pi^2 - 1}$$

$$Y_{Abw} = \frac{2\pi \cdot \cos \frac{2\pi}{N} \cdot X_{DFT} + \left(2\pi \cdot \sin \frac{2\pi}{N} - 1\right) \cdot Y_{DFT}}{4\pi^2 - 1}$$

eines komplexen Kompensationsvektors berechnet. Außer $X_{DFT}$ und $Y_{DFT}$ handelt es sich hierbei nur um Konstanten. Die Berechnung gestaltet sich daher vorteilhaft sehr einfach, schnell und präzise.

Anschließend werden die aktuellen (komplexen) Fourierkoeffizienten, die nach Gleichung (6) aus den abgetasteten Werten der Signale $U_{S1}(t)$, $U_{S2}(t)$ bestimmt werden, mit dem entsprechenden Kompensationsvektor korrigiert und aus diesen korrigierten Fourierkoeffizienten nach Gleichung (7) die Winkellage $\rho$ des Rotors relativ zu den Statorwicklungen, i.e. die Winkellage des Resolvers bestimmt, wie vorstehend beschrieben.

Als erster vorhergehender Fourierkoeffizient kann beispielsweise der Fourierkoeffizient bei stehendem Resolver gewählt werden, bei dem, wie aus Fig. 6, 7 erkennbar, die Abweichung im Wesentlichen verschwindet.

**Patentansprüche**

1. Verfahren zur Bestimmung der Winkellage (p) eines Resolvers mit den Schritten:

   - Erregen einer Erregerwicklung (R) des Resolvers mit einem Referenzsignal (U(t));
   - Abtasten eines aus dem Referenzsignal resultierenden ersten Signals ($U_{S1}(t)$) in einer ersten Wicklung (S1) des Resolvers und eines aus dem Referenzsignal resultierenden zweiten Signals ($U_{S2}(t)$) in einer zweiten Wicklung (S2) des Resolvers;
   - Bestimmung eines unkompensierten Fourierkoeffizienten ($Z_{S1}$) für das erste und eines unkompensierten Fourierkoeffizienten ($Z_{S2}$) für das zweite Signal ($U_{S1}(t)$, $U_{S2}(t)$);
   - Bestimmung der Winkellage (p) des Resolvers aus Fourierkoeffizienten für das erste und für das zweite Signal;
   - Bestimmen eines kompensierten Fourierkoeffizienten ($z_{S1, kom}$) für das erste und eines kompensierten Fourierkoeffizienten ($z_{S2, kom}$) für das zweite Signal ($U_{S1}(t)$, $U_{S2}(t)$); und
   - Bestimmung der Winkellage (p) des Resolvers aus den kompensierten Fourierkoeffizienten ($z_{S1, kom}$, $z_{S2, kom}$); **dadurch gekennzeichnet, dass** die kompensierten Fourierkoeffizienten ($z_{S1, kom}$, $z_{S2, kom}$) derart bestimmt werden, dass sie die Änderung der unkompensierten Fourierkoeffizienten ($z_{S1}$, $z_{S2}$) aufgrund der Phasenverschiebung der Resolversignale innerhalb eines Fourierintervalls und/oder aufgrund der Änderung der Position des Rotors des Resolvers innerhalb eines Fourierintervalls im Wesentlichen ausgleichen.

2. Verfahren nach Anspruch 1, **dadurch gekennzeichnet, dass** das Referenzsignal periodisch, insbesondere sinusförmig ist ($U(t) = U_R \cdot \sin(2\pi \cdot f \cdot t)$).

3. Verfahren nach Anspruch 2, **dadurch gekennzeichnet, dass** das erste und zweite Signal mit einer Frequenz abgetastet wird, die größer als das Doppelte, insbesondere größer als das 2,5-fache der Frequenz des Referenzsignals ist.

**4.** Verfahren nach einem der Ansprüche 2 bis 3, **dadurch gekennzeichnet, dass** das erste und zweite Signal über ein n-faches der Periode des Referenzsignals abgetastet wird, wobei n insbesondere größer oder gleich eins ist, und dass als unkompensierte Fourierkoeffizienten die n-ten Fourierkoeffizienten gewählt sind.

**5.** Verfahren nach einem der vorhergehenden Ansprüche, **dadurch gekennzeichnet, dass** die Winkellage des Resolvers aus dem Quotienten der Fourierkoeffizienten für das erste und für das zweite Signal, insbesondere aus dem Arcustanges dieses Quotienten bestimmt wird.

**6.** Verfahren nach einem der vorhergehenden Ansprüche, **dadurch gekennzeichnet, dass** zunächst eine Referenzwinkellage des Resolvers in einem Referenzoktanten ($[0°, 45°]$) bestimmt und anschließend die Referenzwinkellage, insbesondere in drei oder vier Schritten, in die Winkellage des Resolvers in dem Oktanten eines eine volle Drehung beschreibenden Winkelbereichs ($[0°, 360°]$) umgerechnet wird.

**7.** Verfahren nach einem der vorhergehenden Ansprüche, **dadurch gekennzeichnet, dass** zur Kompensation der Änderung der unkompensierten Fourierkoeffizienten die Phasenverschiebung des Resolvers und/oder die Änderung der Winkellage während der Abtastung durch eine lineare oder eine trigonometrische, insbesondere sinusförmige Hüllkurve approximiert ist.

**8.** Verfahren nach einem der vorhergehenden Ansprüche, **dadurch gekennzeichnet, dass** für das erste und zweite Signal ein kompensierter Fourierkoeffizient auf Basis der Differenz des unkompensierten Fourierkoeffizienten und eines kompensierten Fourierkoeffizienten bestimmt wird, der für einen vorhergehenden Abtastzeitraum bestimmt worden ist.

**9.** Verfahren nach Anspruch 8, **dadurch gekennzeichnet, dass** der vorhergehende Abtastzeitraum das Ein- oder Mehrfache einer Abtastperiode, mit der das erste und zweite Signal abgetastet wird, umfasst.

**10.** Verfahren nach Anspruch 8, **dadurch gekennzeichnet, dass** das erste und zweite Signal periodisch ist und der Abtastzeitraum eine halbe Periode des ersten und zweiten Signals umfasst.

**11.** Vorrichtung zur automatischen Bestimmung der Winkellage ($\rho$) eines Resolvers, die zur Durchführung aller Schritte eines Verfahrens nach einem der vorhergehenden Ansprüche eingerichtet ist, mit Mitteln zum Erregen einer Erregerwicklung (R) des Resolvers mit einem Referenzsignal ($U(t)$);
Mitteln zum Abtasten eines aus dem Referenzsignal resultierenden ersten Signals ($U_{S1}(t)$) in einer ersten Wicklung (S1) des Resolvers und eines aus dem Referenzsignal resultierenden zweiten Signals ($U_{S2}(t)$) in einer zweiten Wicklung (S2) des Resolvers; und
einer Rechen- und Speichereint.

**12.** Computerprogramm, das alle Schritte eines Verfahrens nach einem der Ansprüche 1 bis 10 ausführt, wenn es in einer Vorrichtung nach Anspruch 11 abläuft.

**13.** Computerprogrammprodukt mit Programmcode, der auf einem maschinenlesbaren Träger gespeichert ist und ein Computerprogramm nach Anspruch 12 umfasst.

**Claims**

**1.**

A method for determining an angle ($\varrho$) of a resolver comprising the steps:

- Exciting an excitation winding (R) of the resolver with a reference signal ($U(t)$);
- Sampling a first signal ($U_{S1}(t)$) that results from the reference signal in a first winding (S1) of the resolver and sampling a second signal ($U_{S2}(t)$) that results from the reference signal in a second winding (S2) of the resolver;
- Determining an uncompensated Fourier coefficient ($z_{S1}$) for the first signal and an uncompensated Fourier coefficient ($z_{S2}$) for the second signal ($U_{S1}(t)$, $U_{S2}(t)$);

- Determining an angle ($\varrho$) of the resolver from Fourier coefficients for the first and for the second signal;
- Determining a compensated Fourier coefficient ($z_{S1,kom}$) for the first signal and a compensated Fourier coefficient

($z_{S2, kom}$) for the second signal ($U_{S1}(t)$, $U_{S2}(t)$); and

- Determining an angle ($Q$) of the resolver from the compensated Fourier coefficients ($z_{S1,kom}$, $z_{S2,kom}$) ;
**characterized in that**
the compensated Fourier coefficients ($z_{S1,kom}$ , $z_{S2,kom}$) are determined such that they equalize in principle the change of the uncompensated Fourier coefficients ($z_{S1}$, $z_{S2}$) due to the phase shift of the resolver signals within a Fourier interval and/or due to the change of the position of the rotor of the resolver within a Fourier interval.

2. A method according to claim 1 **characterized in that** the reference signal is periodic, in particular sinusoidal ($U\ (t)$ $=U_R{\cdot}sin\ (2\pi{\cdot}f{\cdot}t)$ ) .

3. A method according to claim 2, **characterized in that** the first and the second signal are sampled with a frequency which is greater than 2-times, in particular greater than 2.5-times of the frequency of the reference signal.

4. A method according to one of the claims 2 to 3, **characterized in that** the first and the second signal are sampled over n-fold of the period of the reference signal, wherein n is in particular greater than or equal to one, and that n-th Fourier coefficients are selected as the the uncompensated Fourier coefficients.

5. A method according to one of the preceding claims, **characterized in that**, the angle of the resolver is determined from the quotient of the Fourier coefficients for the first and for the second signal, in particular from the arc tangent of this quotient.

6. A method according to one of the preceding claims, **characterized in that**, a reference angle of the resolver is determined at first in the reference octant ([0°, 45°]) and afterwards the reference angle is calculated to the angle of the resolver, in particular in three or four steps, within the octant of an angle interval ([0°, 360°]) that describes a full rotation.

7. A method according to one of the preceding claims, **characterized in that** for compensation of the change of the uncompensated Fourier coefficients the phase shift of the resolver and/or the change of the angle during the sampling is approximated by a linear or a trigonometric, in particular a sinusoidal, envelope.

8. A method according to one of the preceding claims, **characterized in that** for the first and the second signal a compensated Fourier coefficient on the basis of the difference of the uncompensated Fourier coefficient and a compensated Fourier coefficient is determined, which is determined for the preceding sampling interval.

9. A method according to claim 8, **characterized in that** the preceding sampling interval comprises one or multiple of a sampling period, by which the first and the second signal is sampled.

10. A method according to claim 8, **characterized in that** the first and the second signal is periodic and the sampling interval comprises a half period of the first and the second signal.

11.
An apparatus for automatically determining an angle ($Q$) of a resolver that is designed for realization of all steps of a method according to one of the preceding claims, with means for exciting an excitation winding (R) of the resolver with a reference signal (U (t) ) ;
means for sampling a first signal ($U_{S1}$ (t) ) that results from a reference signal in a first winding (S1) of the resolver and for sampling a second signal ($U_{S2}$ (t) ) in a second winding (S2) of the resolver that results from the reference signal; and
a computation and storage unit.

12. A computer program that realizes all steps of a method according to one of the claims 1 to 10 if it runs in an apparatus according to claim 11.

13. A computer program product with programming code that is stored on a machine readable carrier and that comprises a computer program according to claim 12.

**Revendications**

1. Procédé pour la détermination de la position angulaire (p) d'un résolveur, comprenant les étapes suivantes :

   - excitation d'un enroulement d'excitation (R) du résolveur par un signal de référence (U(t)) ;
   - lecture d'un premier signal ($U_{S1}(t)$) résultant du signal de référence dans un premier enroulement (S1) du résolveur et d'un deuxième signal ($U_{S2}(t)$) résultant du signal de référence dans un deuxième enroulement (S2) du résolveur ;
   - détermination d'un coefficient de Fourier non compensé ($Z_{S1}$) pour le premier signal ($U_{S1}(t)$) et d'un coefficient de Fourier non compensé ($Z_{S2}$) pour le deuxième signal ($U_{S2}(t)$) ;
   - détermination de la position angulaire (p) du résonateur à partir des coefficients de Fourier pour les premier et deuxième signaux ;
   - détermination d'un coefficient de Fourier compensé ($Z_{S1,kom}$) pour le premier signal ($U_{S1}(t)$) et d'un coefficient de Fourier compensé ($Z_{S2,kom}$) pour le deuxième signal ($U_{S2}(t)$) ; et
   - détermination de la position angulaire (p) du résolveur à partir des coefficients de Fourier compensés ($Z_{S1,kom}$, $Z_{S2,kom}$) ; **caractérisé en ce que** les coefficients de Fourier compensés ($Z_{S1,kom}$, $Z_{S2,kom}$) sont déterminés de manière qu'ils compensent sensiblement la variation des coefficients de Fourier non compensés ($Z_{S1}$, $Z_{S2}$) résultant du déphasage des signaux de résolveur à l'intérieur d'un intervalle de Fourier et/ou de la variation de la position du rotor du résolveur dans les limites d'un intervalle de Fourier.

2. Procédé selon la revendication 1, **caractérisé en ce que** le signal de référence est périodique, en particulier sinusoïdal ($U(t) = U_R \cdot \sin(2\pi \cdot f \cdot t)$).

3. Procédé selon la revendication 2, **caractérisé en ce que** les premier et deuxième signaux sont lus à une fréquence qui est supérieure au double, en particulier à 2,5 fois la fréquence du signal de référence.

4. Procédé selon une des revendications 2 à 3, **caractérisée en ce que** les premier et deuxième signaux sont lus sur n fois la période du signal de référence, où n est en particulier supérieur ou égal à un et **en ce que** les énièmes coefficients de Fourier sont choisis comme coefficients de Fourier non compensés.

5. Procédé selon une des revendications précédentes, **caractérisé en ce que** la position angulaire du résolveur est déterminée à partir du quotient des coefficients de Fourier pour les premier et deuxième signaux, en particulier à partir de l'arc tangente de ce quotient.

6. Procédé selon une des revendications précédentes, **caractérisé en ce que**, tout d'abord, une position angulaire de référence de résolveur est déterminée dans un octant de référence ([0°, 45°]), puis la position angulaire de référence est convertie, en particulier en trois ou quatre pas, en la position angulaire du résolveur dans l'octant d'une plage angulaire décrivant un tour complet ([0°, 360°]).

7. Procédé selon une des revendications précédentes, **caractérisé en ce que**, pour la compensation de la variation des coefficients de Fourier non compensés, le déphasage du résolveur et/ou la variation de la position angulaire pendant la lecture est approchée par une courbe enveloppe linéaire ou trigonométrique, en particulier sinusoïdale.

8. Procédé selon une des revendications précédentes, **caractérisé en ce que**, pour les premier et deuxième signaux, on détermine un coefficient de Fourier compensé sur la base de la différence entre le coefficient de Fourier non compensé et un coefficient de Fourier compensé qui a été déterminé pour un intervalle de lecture précédent.

9. Procédé selon la revendication 8, **caractérisé en ce que** le laps de temps de lecture précédent comprend une ou plusieurs fois une période de lecture avec laquelle les premier et deuxième signaux sont lus.

10. Procédé selon la revendication 8, **caractérisé en ce que** les premier et deuxième signaux sont périodiques et que le laps de temps de lecture couvre une demi-période des premier et deuxième signaux.

11. Dispositif pour la détermination automatique de la position angulaire (p) d'un résolveur qui est conçu pour l'exécution de tous les pas d'un procédé selon une des revendications précédentes, comprenant des moyens pour exciter un enroulement d'excitation (R) du résolveur avec un signal de référence (U(t)) ;
    des moyens pour lire un premier signal ($U_{S1}(t)$ résultant du signal de référence dans un premier enroulement (S1) du résolveur et un deuxième signal ($U_{S2}(t)$ résultant du signal de référence dans un deuxième enroulement (S2) du résolveur et une unité de calcul et de mémoire.

**12.** Programme d'ordinateur qui exécute tous les pas d'un procédé selon une des revendications 1 à 10 lorsqu'il est exécuté dans un dispositif selon la revendication 11.

**13.** Produit programme d'ordinateur comportant un code de programme qui est enregistré sur un support lisible par une machine, et un programme d'ordinateur selon la revendication 12.

**Fig. 1**

**Fig. 2**

**Fig. 3**

**Fig. 4**

**Fig. 5**

**Fig. 6**

**Fig. 7**

Fig. 8

Fig. 9

**Fig. 10**

**Fig. 11**

**Fig. 12**

**Fig.13**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0877464 A2
- US 5241268 A
- US 5684719 A
- EP 1498698 A2